# EUROPÄISCHE PATENTSCHRIFT

(11) **EP 2 664 158 B1**
(45) Veröffentlichungstag und Bekanntmachung des Hinweises auf die Patenterteilung: **16.08.2017**
(21) Anmeldenummer: 11788406.4
(22) Anmeldetag: 14.11.2011
(51) Int. Cl.: H04Q 9/00, G01R 31/36, G06F 13/40, H01M 10/48

(54) **BATTERIEMANAGEMENTEINHEIT MIT EINER VIELZAHL VON ÜBERWACHUNGSEINHEITEN**
BATTERY MANAGEMENT UNIT COMPRISING A PLURALITY OF MONITORING UNITS
UNITÉ DE GESTION DE BATTERIE COMPRENANT UNE PLURALITÉ D'UNITÉS DE SURVEILLANCE

(30) Priorität: 13.01.2011 DE 102011002632
(43) Veröffentlichungstag der Anmeldung: 20.11.2013
(73) Patentinhaber: Robert Bosch GmbH, 70442 Stuttgart (DE); Samsung SDI Co., Ltd., Yongin-si Gyeonggi-do 446-577 (KR)
(72) Erfinder: BUTZMANN, Stefan, 71717 Beilstein (DE)
(74) Vertreter: Bee, Joachim
(86) Internationale Anmeldenummer: PCT/EP2011/070002
(87) Internationale Veröffentlichungsnummer: WO 2012/095202

(56) Entgegenhaltungen:
- WO-A1-2009/029534
- DE-A1-102004 033 761
- US-A- 5 773 962

## Beschreibung

Die vorliegende Erfindung betrifft eine Batteriemanagementeinheit mit einer Vielzahl von Überwachungseinheiten, eine Batterie mit der erfindungsgemäßen Batteriemanagementeinheit sowie ein Kraftfahrzeug mit der erfindungsgemäßen Batterie.

### Stand der Technik

Insbesondere in Hybrid- und Elektrofahrzeugen werden heute Batterien in Lithium-Ionen- oder Nickel-Metallhydrid-Technologie eingesetzt, die eine große Anzahl in Serie geschalteter elektrochemischer Batteriezellen aufweisen. Eine Batteriemanagementeinheit wird zur Überwachung der Batterie eingesetzt und soll neben einer Sicherheitsüberwachung eine möglichst hohe Lebensdauer gewähren. Dazu wird die Spannung jeder einzelnen Batteriezelle zusammen mit dem Batteriestrom und der Batterietemperatur gemessen und eine Zustandsschätzung (beispielsweise des Ladezustandes oder des Alterungszustandes der Batterie) vorgenommen. Um die Lebensdauer zu maximieren, ist es hilfreich, jederzeit die aktuell gegebene maximale Leistungsfähigkeit der Batterie, also die maximal abgeb- oder aufnehmbare elektrische Leistung, zu kennen. Wird diese Leistungsfähigkeit überschritten, kann die Alterung der Batterie stark beschleunigt werden.

Um eine genaue Messung der Spannung jeder einzelnen Batteriezelle oder zumindest der Spannung jedes Batteriemoduls, welches eine vorbestimmte Anzahl von Batteriezellen umfasst, zu ermöglichen, sind aus dem Stand der Technik Batteriemanagementeinheiten bekannt, welche eine Vielzahl von hintereinandergeschalteten Überwachungs-Chips, also integrierten Schaltungen, umfassen, welche unter anderem Spannungsmessungen ausführen können und in Form einer Daisy-Chain an einen ersten Bus angeschlossen sind, welcher eine Kommunikation zwischen den einzelnen Überwachungseinheiten ermöglicht, ohne galvanische Trennungen oder den Einsatz von Hochvoltelektronik erforderlich zu machen. Die Überwachungseinheiten liegen hierbei mit ihren Versorgungsspannungen, welche von den zu überwachenden Batteriezellen oder Batteriemodulen geliefert werden, in einer Spannungskette und kommunizieren untereinander derart, dass jede Überwachungseinheit nur mit einer benachbarten Überwachungseinheit kommuniziert und die Kommunikationsdaten, welche von Überwachungseinheiten stammen, welche ein höheres Spannungsniveau aufweisen, an die jeweils tiefer im Spannungsniveau liegende Überwachungseinheit durchreicht.

Am hinsichtlich des Spannungsniveaus tiefstliegenden Ende des Kommunikationsbusses wird eine Basis-Überwachungseinheit angeordnet, welche ebenfalls an den ersten Kommunikationsbus angeschlossen ist und welche Nachrichten von jeder der Überwachungseinheiten empfangen kann. Außerdem ist die Basis-Überwachungseinheit über einen zweiten Bus mit einem Steuergerät verbunden, welches über diese die weitergereichten Daten empfängt. Zwischen der Basis-Überwachungseinheit und dem Steuergerät wird gewöhnlicherweise eine galvanische Trennung vorgenommen.

Die Überwachungseinheiten werden gewöhnlich in der Nähe der ihnen zugeordneten Batteriemodule platziert und die Verbindungen für die Kommunikation über den ersten und zweiten Bus durch den Einbau von Kabelbäumen realisiert.

Aus dem Stand der Technik sind Anwendungsspezifische Integrierte Schaltungen (ASIC) bekannt, welche nach dem Baukastenprinzip entweder als Basis-Überwachungseinheit am unteren Ende der Spannungskette - also mit einer Schnittstelle zur Kommunikation mit dem Steuergerät sowie einer Schnittstelle zur Kommunikation mit einer weiteren Überwachungseinheit in einer Spannungskette -, oder auch als Überwachungseinheit in der Daisy-Chain konfiguriert werden können.

Während der erste Bus, welcher zur ersten Kommunikation zwischen den einzelnen Überwachungseinheiten verwendet wird, gewöhnlich auf reduzierte EMV (elektromagnetische Verträglichkeit)-Abstrahlung und eine erhöhte Einstrahlungsfestigkeit ausgelegt ist, ist der zweite Bus, welcher für die Kommunikation mit dem Steuergerät verwendet wird, gewöhnlich ein genormter und nicht proprietärer Bus, der zur Kommunikation mit einem vom Steuergerät umfassten Mikrocontroller geeignet ist. Hierbei wird oft ein Protokoll verwendet, welches unter dem Gesichtspunkt der elektromagnetischen Verträglichkeit nicht dazu gedacht ist, über eine längere Distanz hinweg über ein Kabel geführt zu werden.

Die US 5,773,962 offenbart eine Überwachungs- und Steuereinheit für eine Batterie mit einer langen Kette an in Serie verschalteten Batteriezellen beziehungsweise Batteriemodulen, wobei die Überwachungs- und Steuereinheit eine Hauptüberwachungseinheit und mindestens ein Batterieüberwachungsmodul aufweist, welche über eine Bussystem miteinander verbunden sind.

Die DE 10 2004 033 761 A1 offenbart eine Vorrichtung und ein Verfahren zum Datenaustausch auf mehreren Bussystemen, wobei die Vorrichtung mindestens zwei Datenbussysteme mit mindestens einer Steuereinheit zur Abarbeitung von Schnittstellenbezogenen Funktionen aufweist.

Die WO 2009/029534 A1 offenbart eine modulare und skalierbare Energiequelle, die einen Controller sowie eine Vielzahl in Serie verschalteter Batteriemodule aufweist, welche eine Vielzahl von parallel verschalteten Batteriezellen aufweisen und einen Überwachungsschaltkreis umfasst, welcher einen oder mehrere Parameter der Batteriemodule überwacht.

### Offenbarung der Erfindung

Erfindungsgemäß wird eine Batteriemanagementeinheit mit einer Vielzahl von Überwachungseinheiten bereitgestellt. Jede der Überwachungseinheiten ist dazu ausgebildet, mindestens eine Betriebsgröße mindestens einer Batteriezelle zu erfassen. Außerdem ist jede der Überwachungseinheiten an einen ersten Bus angeschlossen. Die Batteriemanagementeinheit umfasst des Weiteren ein Steuergerät, welches ebenfalls an den ersten Bus angeschlossen und dazu ausgebildet ist, über den ersten Bus mit mindestens einer der Überwachungseinheiten zu kommunizieren. Das Steuergerät umfassteinen Mikrocontroller und eine Übersetzungseinheit, wobei die Übersetzungseinheit an den ersten Bus angeschlossen und dazu ausgebildet ist, über den ersten Bus mit mindestens einer der Überwachungseinheiten zu kommunizieren und wobei der Mikrocontroller und die Übersetzungseinheit an einen zweiten Bus angeschlossen und dazu ausgebildet sind, über den zweiten Bus miteinander zu kommunizieren. Die Übersetzungseinheit ist ferner dazu ausgebildet, über den ersten Bus unter Verwendung eines ersten Busprotokolls und über den zweiten Bus unter Verwendung eines zweiten Busprotokolls zu kommunizieren. Dabei ist der zweite Bus als SPI (Serial Peripheral Interface)-Bus oder als I²C (Inter-Integrated Circuit)-Bus oder als CAN (Controller Area Network)-Bus ausgeführt und so angeordnet, dass er gegen elektromagnetische Einstrahlung und Abstrahlung geschützt ist.

Typischerweise wird als erstes Busprotokoll, welches der Kommunikation zwischen den einzelnen Überwachungseinheiten und der Weiterleitung von deren Daten an die Übersetzungseinheit dient, ein solches verwendet, welches ermöglicht, dass die zum ersten Bus gehörigen Kabel über längere Distanz zwischen verschiedenen Leiterplatten, welche einzelnen Batteriezellen oder Batteriemodulen zugeordnet sind, geführt werden, und welches derart gewählt ist, dass es in Hinsicht auf elektromagnetische Verträglichkeit beständig sowie hinreichend robust gegenüber Störeinstrahlung ist. Es handelt sich hierbei oft um ein differentielles, nicht genormtes Protokoll.

Hingegen wird als zweites Busprotokoll, welches der Kommunikation zwischen der Übersetzungsseinheit und dem Mikrocontroller dient ein solches verwendet, welches genormt ist und nicht dazu ausgelegt ist, über eine längere Distanz auf einem Kabel geführt zu werden.. Ein solches Protokoll erzeugt bezüglich der elektromagnetischen Verträglichkeit einen hohen Abstrahlungsgrad, da oft hohe Datenraten ohne differentiellen Bus übertragen werden. Andererseits ist das verwendete Protokoll empfindlich gegen elektromagnetische Einstrahlung, da die Daten single ended übertragen werden. Wenn sich hierbei auf ein Kabel des zweiten Busses additive Störsignale legen, die von einer externen Störquelle stammen, kann dies dazu führen, dass das zweite Busprotokoll von den angeschlossenen Komponenten nicht mehr verstanden wird.

Dadurch, dass die Übersetzungsseinheit und der Mikrocontroller gemeinsam in dem Steuergerät angeordnet sind, braucht der zweite Bus nicht über lange Distanzen gelegt zu werden und ist so angeordnet, dass er gegen elektromagnetische Einstrahlung und Abstrahlung geschützt ist.

Bevorzugt ist außerdem, dass wenigstens einige der Überwachungseinheiten an den ersten Bus in einer Daisy-Chain-Topologie angeschlossen sind.

Wenigstens einige der Überwachungseinheiten können insbesondere dazu ausgebildet sein, eine Spannung einer Batteriezelle oder eines Batteriemoduls zu erfassen.

Wenigstens einige der Überwachungseinheiten können integrierte Schaltkreise sein. Das Gleiche gilt für die Übersetzungseinheit. Besonders vorteilhaft ist es, wenn wenigstens einige der Überwachungseinheiten und auch die Übersetzungseinheit baugleiche Teile, insbesondere baugleiche integrierte Schaltkreise, sind, welche bestimmungsgemäß konfiguriert sind. Typischerweise handelt es sich bei den Bauteilen um konfigurierbare Anwendungsspezifische Integrierte Schaltungen (ASIC).

Ein weiterer Aspekt der Erfindung betrifft eine Batterie mit einer erfindungsgemäßen Batteriemanagementeinheit, bevorzugt eine Lithium-Ionen-Batterie, sowie ein Kraftfahrzeug mit einer erfindungsgemäßen Batterie.

### Zeichnungen

Ausführungsbeispiele der Erfindung werden anhand der Zeichnungen und der nachfolgenden Beschreibung näher erläutert. Es zeigen:
Figur 1 eine Batteriemanagementeinheit nach dem Stand der Technik, und
Figur 2 eine Batteriemanagementeinheit gemäß einer Ausführung der Erfindung.

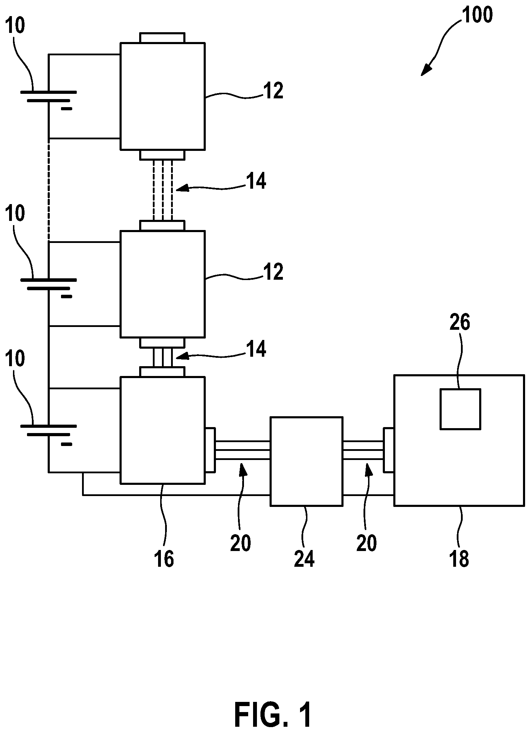

Figur 1 zeigt eine Batteriemanagementeinheit nach dem Stand der Technik, welche Teil einer insgesamt mit 100 bezeichneten Batterie ist. Die Batteriemanagementeinheit umfasst eine Vielzahl von Überwachungseinheiten 12, welche in einer Daisy-Chain-Topologie an einen ersten Bus 14 angeschlossen sind. Jede der Überwachungseinheiten 12 ist dazu ausgebildet, eine Spannung zu erfassen, welche an einem ihr zugeordneten Batteriemodul 10 anliegt, wobei das Batteriemodul 10 eine vorbestimmte Anzahl von Batteriezellen, beispielsweise sechs bis zwölf Batteriezellen, umfasst (in Figur 1 lediglich schematisch dargestellt). Hierbei wird die erfasste Spannung über einen Multiplexer einem Analog-Digital-Konverter zugeführt, und anschließend die digitalisierte Spannung auf den ersten Bus 14 übermittelt. Das Batteriemodul 10 kann auch nur eine Batteriezelle umfassen, in welchem Fall die der Batteriezelle zugeordnete Überwachungseinheit 12 die Einzelspannung an der Batteriezelle misst.

Die Vielzahl von Batteriemodulen 10 ist in Reihe geschaltet. Jedes Batteriemodul 10 liefert eine Versorgungsspannung an die ihm zugeordnete Überwachungseinheit 12, so dass sich die Vielzahl von Überwachungseinheiten 12 in einer aufsteigenden Spannungskette befindet.

Jede Überwachungseinheit 12 empfängt über den ersten Bus 14 Daten von einer ihr gegebenenfalls in der Spannungskette übergeordneten Überwachungseinheit 12 und reicht die empfangenen Daten zusammen mit Daten, welche von ihr selbst erzeugt werden, an die benachbarte Überwachungseinheit 12 durch, welche in der Spannungskette tiefer gelegen ist. Am unteren Ende der Spannungskette ist eine Basis-Überwachungseinheit 16 angeordnet, welche alle durchgereichten Daten, die von den Überwachungseinheiten 12 stammen, empfängt und über einen zweiten Bus 20, an den sie angeschlossen ist, an ein Steuergerät 18 weiterreicht, welches ebenfalls an den zweiten Bus 20 angeschlossen ist und einen Mikrocontroller 26 umfasst.

Jede Überwachungseinheit 12 ist auf einer eigenen Leiterplatine angeordnet, welche in der Nähe des ihr zugeordneten Batteriemoduls 10 angeordnet ist. Bei den Überwachungseinheiten 12 und der Basis-Überwachungseinheit 16 handelt es sich um baugleiche Anwendungsspezifische Integrierte Schaltungen, welche bestimmungsgemäß konfigurierbar sind, so dass sie wie beschrieben mit den übrigen baugleichen Teilen kommunizieren können.

Der erste Bus 14 verwendet ein differentielles Protokoll, welches in Hinblick auf Robustheit und elektromagnetische Verträglichkeit so gewählt ist, dass die Kabel des ersten Busses 14 über eine längere Distanz und über mehrere Leiterplatinen hinweg geführt sein können, ohne dass die Kommunikation auf dem ersten Bus 14 gestört wird.

Hingegen wird auf dem zweiten Bus 20 ein Busprotokoll verwendet, welches single ended übertragen wird und für eine Kommunikation mit dem Mikrocontroller 26 optimiert ist. Ein solches Protokoll ist in Hinblick auf die elektromagnetische Verträglichkeit störanfälliger und insbesondere nicht dazu ausgelegt, über eine längere Distanz eines Kabels übertragen zu werden. Nachteilhaft an der in Figur 1 dargestellten Anordnung ist, dass je nach Design der Batterie 100 von der Basis-Überwachungseinheit 16 zum Steuergerät 18 erhebliche Distanzen zu überbrücken sein können, da typischerweise beide Bauteile auf verschiedenen Leiterplatten angeordnet sind.

Eine galvanische Trennungseinheit 24 trennt die Basis-Überwachungseinheit 16 und einen ersten Teil des zweiten Busses 20 einerseits und einen zweiten Teil des zweiten Busses 20 und das Steuergerät 18 andererseits voneinander. In der galvanischen Trennungseinheit 24 ist außerdem eine Spannungsversorgung des ersten Teils des zweiten Busses 20 vorgesehen.

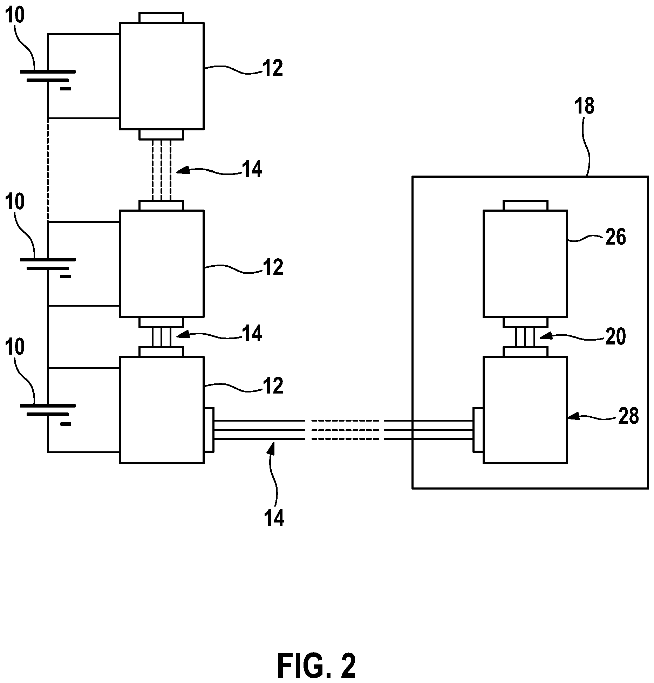

Figur 2 zeigt eine Batteriemanagementeinheit gemäß einer Ausführung der Erfindung. Im Gegensatz zu der in Figur 1 dargestellten Batteriemanagementeinheit nach dem Stand der Technik weist die erfindungsgemäße Batteriemanagementeinheit ein Steuergerät 18 auf, welches neben dem Mikrocontroller 26 eine Übersetzungseinheit 28 umfasst, welche an den ersten Bus 14 angeschlossen ist und über diesen mit der in der Spannungskette tiefstgelegenen Überwachungseinheit 12 kommuniziert. Der Mikrocontroller 26 und die Übersetzungseinheit 28 kommunizieren miteinander über den zweiten Bus 20, an den beide angeschlossen sind. Bei den Überwachungseinheiten 12 und der Übersetzungseinheit 28 handelt es sich um baugleiche Anwendungsspezifische Integrierte Schaltungen, welche bestimmungsgemäß konfigurierbar sind, so dass sie wie beschrieben mit den übrigen baugleichen Teilen kommunizieren können.

Aufgabe der Übersetzungseinheit 28 ist es, innerhalb des Steuergeräts 18 Nachrichten vom ersten Bus 14 auf den zweiten Bus 20 zu übertragen und somit eine Übersetzung vom auf dem ersten Bus 14 verwendeten Protokoll in das auf dem zweiten Bus 20 verwendete Protokoll durchzuführen.

Die erfindungsgemäße Anordnung kann durch Modifikation der in Figur 1 gezeigten Anordnung erreicht werden, indem die in Figur 1 gezeigte Basis-Überwachungseinheit 16 in das Steuergerät 18 verlegt wird, so dass sie als Übersetzungseinheit 28 dienen kann. Allerdings ist die Übersetzungseinheit 28 anders als die in Figur 1 gezeigte Basis-Überwachungseinheit 16 keinem Batteriemodul 10 zugeordnet. Vielmehr sind lediglich die übrigen Überwachungseinheiten 12 jeweils einem Batteriemodul 10 zugeordnet, deren Spannung sie messen. Dadurch, dass die Übersetzungseinheit 28 keinem Batteriemodul zugeordnet ist, sondern die Aufgabe einer Hilfsschaltung übernimmt, ist es nicht erforderlich, Messkabel von einem Batteriemodul in das Steuergerät 18 zu führen.

Die Übersetzungseinheit 28 empfängt die von den in der Daisy-Chain-Topologie angeordneten Überwachungseinheiten 12 durchgereichten Daten über den ersten Bus 14 und sendet diese über den zweiten Bus 20 an den Mikrocontroller 26. Dadurch, dass sowohl die Übersetzungseinheit 28 als auch der Mikrocontroller 26 im Steuergerät 18 angeordnet sind, ist die Distanz des zwischen dem Mikrocontroller 26 und der Übersetzungseinheit 28 verlaufenden zweiten Busses 20 sehr klein gehalten, so dass dieser gegen elektromagnetische Einstrahlung und Abstrahlung geschützt ist. Die gegebenenfalls große Distanz zwischen der in der Spannungskette tiefstgelegenen Überwachungseinheit 12 und der Übersetzungseinheit 28 wird über einen Teil des ersten Busses 14 überbrückt, welcher ein Protokoll verwendet, welches dazu ausgelegt ist, über eine längere Distanz hinweg über ein Kabel geführt zu werden.

## Patentansprüche

1. Batteriemanagementeinheit mit einer Vielzahl von Überwachungseinheiten (12), wobei jede der Überwachungseinheiten (12) dazu ausgebildet ist, mindestens eine Betriebsgröße mindestens einer Batteriezelle oder eines Batteriemoduls (10), welches eine vorbestimmte Anzahl von Batteriezellen umfasst, zu erfassen, und wobei jede der Überwachungseinheiten (12) an einen ersten Bus (14) angeschlossen ist, und mit einem Steuergerät (18), wobei
das Steuergerät (18) ebenfalls an den ersten Bus (14) angeschlossen und dazu ausgebildet ist, über den ersten Bus (14) mit mindestens einer der Überwachungseinheiten (12) zu kommunizieren
**dadurch gekennzeichnet, dass**
das Steuergerät einen Mikrocontroller (26) und eine Übersetzungseinheit (28) umfasst, wobei die Übersetzungseinheit (28) an den ersten Bus (14) angeschlossen und dazu ausgebildet ist, über den ersten Bus (14) mit mindestens einer der Überwachungseinheiten (12) zu kommunizieren, wobei der Mikrocontroller (26) und die Übersetzungseinheit (28) an einen zweiten Bus (20) angeschlossen und dazu ausgebildet sind, über den zweiten Bus (20) miteinander zu kommunizieren, wobei die Übersetzungseinheit (28) dazu ausgebildet ist, über den ersten Bus (14) unter Verwendung eines ersten Busprotokolls und über den zweiten Bus (20) unter Verwendung eines zweiten Busprotokolls zu kommunizieren, wobei der zweite Bus (20) als SPI (Serial Peripheral Interface)-Bus oder als I²C (Inter-Integrated Circuit)-Bus oder als CAN (Controller Area Network)-Bus ausgeführt und so angeordnet ist, dass er gegen elektromagnetische Einstrahlung und Abstrahlung geschützt ist.

2. Batteriemanagementeinheit nach einem der vorangehenden Ansprüche, wobei die Übersetzungseinheit (28) ein integrierter Schaltkreis ist.

3. Batteriemanagementeinheit nach einem der vorangehenden Ansprüche, wobei wenigstens einige der Überwachungseinheiten (12) an den ersten Bus (14) in einer Daisy-Chain-Topologie angeschlossen sind.

4. Batteriemanagementeinheit nach einem der vorangehenden Ansprüche, wobei wenigstens einige der Überwachungseinheiten (12) integrierte Schaltkreise sind.

5. Batteriemanagementeinheit nach einem der vorangehenden Ansprüche, wobei wenigstens einige Überwachungseinheiten (12) dazu ausgebildet sind, eine Spannung einer Batteriezelle oder eines Batteriemoduls (10) zu erfassen.

6. Batteriemanagementeinheit nach einem der vorangehenden Ansprüche, wobei wenigstens einige der Überwachungseinheiten (12) sowie die Übersetzungseinheit (28) baugleiche Teile, insbesondere baugleiche integrierte Schaltkreise, sind, welche bestimmungsgemäß konfiguriert sind.

7. Batterie (100) mit einer Vielzahl von Batteriezellen (10) und einer Batteriemanagementeinheit nach einem der vorangehenden Ansprüche.

8. Kraftfahrzeug, insbesondere elektrisches Kraftfahrzeug, umfassend eine Batterie nach Anspruch 7.

## Claims

1. Battery management unit comprising a plurality of monitoring units (12), each of the monitoring units (12) being designed to record at least one operating variable of at least one battery cell or battery module (10) which comprises a predetermined number of battery cells, and each of the monitoring units (12) being connected to a first bus (14), and comprising a control device (18),
wherein
the control device (18) is likewise connected to the first bus (14) and is designed to communicate with at least one of the monitoring units (12) via the first bus (14),
**characterized in that**
the control device comprises a microcontroller (26) and a translation unit (28), the translation unit (28) being connected to the first bus (14) and being designed to communicate with at least one of the monitoring units (12) via the first bus (14), the microcontroller (26) and the translation unit (28) being connected to a second bus (20) and being designed to communicate with one another via the second bus (20), the translation unit (28) being designed to communicate via the first bus (14) using a first bus protocol and via the second bus (20) using a second bus protocol, the second bus (20) being designed as an SPI (Serial Peripheral Interface) bus or as an I²C (Inter-Integrated Circuit) bus or as a CAN (Controller Area Network) bus and being arranged so that it is protected from electromagnetic irradiation and emission.

2. Battery management unit according claim 1, the translation unit (28) being an integrated circuit.

3. Battery management unit according to one of the preceding claims, at least some of the monitoring units (12) being connected to the first bus (14) in a daisy chain topology.

4. Battery management unit according to one of the preceding claims, at least some of the monitoring units (12) being integrated circuits.

5. Battery management unit according to one of the preceding claims, at least some monitoring units (12) being designed to record a voltage of a battery cell or battery module (10).

6. Battery management unit according to one of the preceding claims, at least some of the monitoring units (12) and the translation unit (28) being structurally identical parts, in particular structurally identical integrated circuits which are configured as intended.

7. Battery (100) comprising a plurality of battery cells (10) and a battery management unit according to one of the preceding claims.

8. Motor vehicle, in particular an electric motor vehicle, comprising a battery according to Claim 7.

## Revendications

1. Unité de gestion de batterie comprenant une pluralité d'unités de surveillance (12), dans laquelle chacune des unités de surveillance (12) est conçue en vue de détecter au moins une grandeur de fonctionnement d'au moins une cellule de batterie ou d'un module de batterie (10), lequel comprend un nombre prédéterminé de cellules de batterie, et dans laquelle chacune des unités de surveillance (12) est raccordée à un premier bus (14), et comprenant également un appareil de commande (18), dans laquelle l'appareil de commande (18) est également raccordé au premier bus (14) et conçu en vue de communiquer avec au moins l'une des unités de surveillance (12) par l'intermédiaire du premier bus (14),
**caractérisée en ce que**
l'appareil de commande comprend un microcontrôleur (26) et une unité de transmission (28), dans laquelle l'unité de transmission (28) est raccordée au premier bus (14) et conçue en vue de communiquer avec au moins l'une des unités de surveillance (12) par l'intermédiaire du premier bus (14), dans laquelle le microcontrôleur (26) et l'unité de transmission (28) sont raccordés à un deuxième bus (20) et conçus en vue de communiquer l'un avec l'autre par l'intermédiaire du deuxième bus (20), dans laquelle l'unité de transmission (28) est conçue en vue de communiquer au moyen d'un premier protocole de bus par l'intermédiaire du premier bus (14), d'une part, et en vue de communiquer au moyen d'un deuxième protocole de bus par l'intermédiaire du deuxième bus (20), d'autre part , dans laquelle le deuxième bus (20) est exécuté sous la forme d'un bus de données SPI (Serial Peripheral Interface), c'est-à-dire un bus à interface périphérique sérielle, ou sous la forme d'un bus de données I²C (Inter-Integrated Circuit) ou encore sous la forme d'un bus de données CAN (Controller Area Network), c'est à dire d'un bus de réseau local de commande, et est disposé de telle sorte qu'il est protégé contre les interférences et les émissions électromagnétiques.

2. Unité de gestion de batterie selon la revendication un, dans laquelle l'unité de transmission (28) est un circuit de commutation intégré.

3. Unité de gestion de batterie selon l'une des revendications ci-dessus, dans laquelle au moins quelques-unes des unités de surveillance (12) sont raccordées au premier bus (14) dans une topologie de type « Daisy Chain ».

4. Unité de gestion de batterie selon l'une des revendications ci-dessus, dans laquelle au moins quelques-unes des unités de surveillance (12) sont des circuits de commutation intégrés.

5. Unité de gestion de batterie selon l'une des revendications ci-dessus, dans laquelle au moins quelques-unes des unités de surveillance (12) sont conçues en vue de détecter une tension d'une cellule de batterie ou d'un module de batterie (10).

6. Unité de gestion de batterie selon l'une des revendications ci-dessus, dans laquelle au moins quelques-unes des unités de surveillance (12) ainsi que l'unité de transmission (28) sont des pièces structurellement identiques, en particulier des circuits de commutation intégrés structurellement identiques, lesquels sont configurés conformément à la finalité d'origine.

7. Batterie (100) comprenant une pluralité de cellules de batterie (10) et une unité de gestion de batterie selon l'une des revendications ci-dessus.

8. Véhicule à moteur, en particulier véhicule à moteur électrique, comprenant une batterie selon la revendication 7.
